# EUROPEAN PATENT APPLICATION

(11) **EP 4 600 668 A1**
(43) Date of publication of application: **13.08.2025**
(21) Application number: 24157112.4
(22) Date of filing: 12.02.2024
(51) Int. Cl.: G01R 21/133, G01R 22/06, G01D 4/00

(54) **A SUBSTATION ELECTRICITY METERING EQUIPMENT AND ARRANGEMENT**

(71) Applicant: Aidon Oy, 40100 Jyväskylä (FI)
(72) Inventor: Sievänen, Aleksi, 40100 Jyväskylä (FI); Lohvansuu, Juha, 40100 Jyväskylä (FI)
(74) Representative: Berggren Oy

(57) **Abstract**

A substation electricity metering equipment according to the comprises at least two metering units (8A, 8B, 8C), which are connected in series in a daisy chain configuration. Each metering unit is connected to at least one current transformer (9) in order to measure current/s in a cable/s of a distribution line (6). Each metering unit comprises a communication line element (14). The communication line elements of the metering units are connected in series forming a communication bus (15). The communication bus may have an extension line, which is connectable to a gateway unit (10). The arrangement further comprises a power source unit (17) connected to one metering unit in said series.

## Description

### Field of technology

The invention relates to arrangements to measure electric power in a substation.

### Prior art

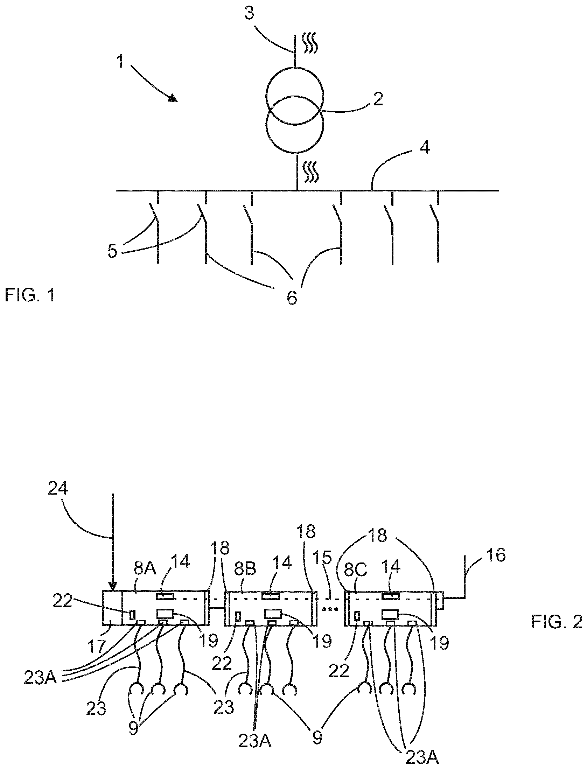

It is known to measure electric consumption in a substation. A substation is a station wherein the voltage level of a transmission line is transformed to a lower voltage level of distribution lines. Figure 1 illustrates a schematic example of a substation 1 wherein a transformer 2 is connected to a transmission line 3 and to a substation's distribution rail 4. Distribution lines 6 are connected to the distribution rail via circuit breakers 5. Because the electric network is a three-phase network, the elements of figure 1 represent a three-phase system although figure 1 illustrates only one line for said elements. The distribution lines 6 can be three-phase, two-phase or one-phase lines depending on consumers systems.
Known arrangements to measure electric power in a substation have electricity metering device for each distribution line 6. Each metering device unit has a power supply and may havea display, and has also a communication unit for further processing electricity data (like power data) in a destination, like a monitoring center of an electric power company. The metering devices requires space and wiring. The system can be complex. Each metering device requires space, which is often limited in a substation. Therefore, the whole system in the substation is often cramped. Maintenance work in the substation can also be very tedious.

### Short description

The object of the invention is to make an alternative solution in order to alleviate the problems of known embodiments. The object is achieved in a way described in an independent claim. Dependent claims describe different embodiments of the invention.

A substation electricity metering equipment, according to the invention comprises at least one metering unit 8A, 8B, 8C, which has at least two distribution line modules 23A. Each distribution line module is connected to at least one current transformer 9 in order to measure current/s in a cable/s of a distribution line 6. The metering equipment further comprises a power source unit 17 connected to or comprised in one of the metering units 8A, 8B, 8C.

Said at least one metering unit 8A, 8B, 8C comprises also a communication line element 14 and interface/s 18 in order to connect the metering units in series. The interface/s are arranged to connect the communication line elements 14 of the metering units in series. The communication line element/s together with the interface/s form a communication bus (15) connectable to an external device. The interface/s are also arranged to transmit power from the power source unit 1.

The communication bus may have an extension line, which can be connected to another device, like a gateway unit.

A substation electricity metering arrangement according to the invention comprises the above said metering equipment and also a gateway unit. The communication bus is connected to the gateway unit, directly or via the extension line 16.The inventive equipment and arrangement are distributed systems, which are scalable to the size and requirements of the substation. The gateway unit takes care of the electricity data communication from all distribution lines to an external destination. Locally one display can be used to look at electricity data of each distribution line. The metering units can be situated near each distribution line, and the gateway unit to a suitable place away from the distribution lines, or in series with the metering units.

### List of figures

In the following, the invention is described in more detail by reference to the enclosed drawings, where
- Figure 1: illustrates an example of a substation,
- Figure 2: illustrates an example of a metering equipment according to the invention,
- Figure 3: illustrates an example of a substation electricity metering arrangement according to the invention and,
- Figure 4: illustrates example of a metering unit.

### Description of the invention

Figure 2 illustrates an example of the inventive substation metering equipment. A substation electricity metering equipment, according to the invention comprises at least one metering unit 8A, 8B, 8C, which has at least two distribution line modules 23A. Each distribution line module is connected to at least one current transformer 9 in order to measure current/s in a cable/s of a distribution line 6. The metering equipment further comprises a power source unit 17 connected to or comprised in one of the metering units 8A, 8B, 8C.

Said at least one metering unit 8A, 8B, 8C comprises also a communication line element 14 and interface/s 18 in order to connect the metering units in series. The interface/s are arranged to connect the communication line elements 14 of the metering units in series. The communication line element/s together with the interface/s form a communication bus (15) connectable to an external device. The interface/s are also arranged to transmit power from the power source unit 1.

So, the metering equipment comprises at least one metering unit 8A, 8B, 8C, The metering units are connectable in series, The communication bus may have an extension line 16. The communication bus is connectable4 to an external device, like a gateway unit 10.

As said the metering units 8A, 8B, 8C comprise interface/s 18 in order to connect the metering units in series. The interfaces 18 are arranged to transmit power and data. The interfaces can be connected directly together, or using, for example a connection cable.

The power source unit 17 is arranged to receive a supply voltage 24, and arranged to transmit supply voltage information to the metering equipment whereto the power source unit 17 is connected to or comprised in. Said interface/s are arranged to transmit the supply voltage information to the other metering units. The supply voltage information comprises a voltage amplitude, phase, and other possible information. So each metering unit gets power, and also the supply voltage information, from the power supply unit 17.

Each metering unit 8A, 8B, 8C comprises at least one processing unit 19 to process measurements of the current transformers 9 and the supply voltage information in order to communicate measurement data via the communication bus 15. The processing unit/s 19 is arranged to calculate electrical power data from the measurements of the current transformers 9 and the supply voltage information to transmit power data via the communication bus 15.

Said the power source 17 can be an integrated element of the first or the other metering unit 8A, or a separate element connected to the first or the other metering unit 8A. It is arranged to get a supply voltage 24.

As described, the metering unit 8A, 8B, 8C, has at least two distribution line modules 23A. Each distribution line module is connected to at least one current transformer 9 in order to measure current/s in a cable/s of a distribution line 6. For example, 1 - 4, current transformers are used in order to measure current/s in a cable/s of a distribution line. Measurement cables 23 and the current transformers are illustrated as single lines/objects per a distribution line. So, one line and object (current transformer) may illustrate even more cables and current transformers than one, like 2-4 cables/transformers.

So, one distribution line module 23A is arranged to handle current measurement connections and measurements from the current transformer/s of one distribution line. It may also be arranged to handle some functions of the processing unit 19 to process measurements of the current transformers 9. It also possible that each distribution line module has its own processing unit 19.

The current transformers 9 are clamp type current transformers. Each distribution line module 23A may have also a voltage meter in order to utilize the supply voltage information (indicating for example voltage level in a substation's distribution rail 4). The communication bus is connectable to an external device, like a communication device, the gateway unit etc.

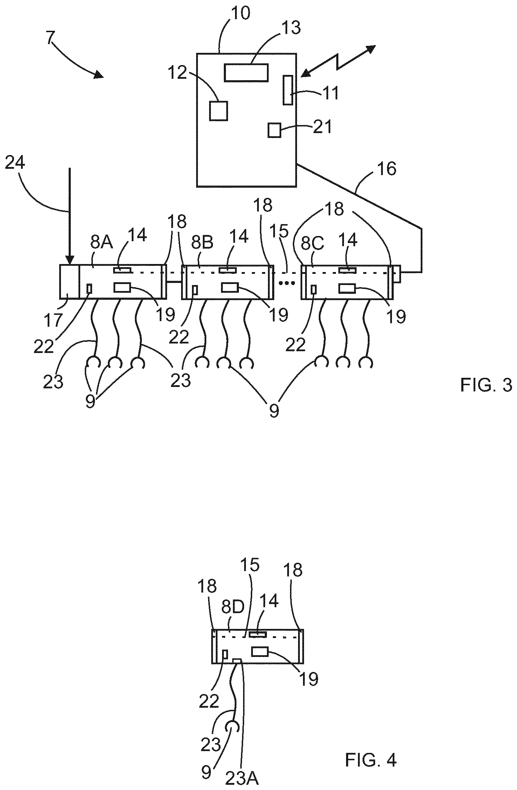

Figure 3 illustrates a schematic example of the inventive arrangement comprising the metering equipment described above. So, a substation electricity metering arrangement according to this example of the invention comprises a metering equipment, a communication unit, at least one processor and, optionally, a display. The arrangement 7 comprises also a gateway unit 10 having said communication unit 11, said at least one processor 12, and optionally the display 13.

As said, the metering equipment comprises at least twoone metering units 8A, 8B, 8C, which are connected in series. Each metering unit has at least two distribution line modules 23A, each distribution line module being connected to at least one current transformer 9, like connected to 1 - 4 current transformers 9 in order to measure current/s in a cable/s of a distribution line 6. The metering units can be situated near the distribution lines 6 and the fuses/circuit breakers 5 wherein the current transformers are easy to connect to the cables of distribution lines and the metering units. Measurement cables 23 can be used to connect the current transformers to the metering units utilizing the distribution line modules 23A.

The gateway unit can be situated away from the distribution lines, for example, to a suitable visible place, where the display 13 is easy to see. The gateway unit can also be connected with the metering units in series, like a last device in series. Since the metering units can be connected in series as many as needed, the arrangement is scalable to the substations of different sizes.

Each metering unit 8A, 8B, 8C comprises a communication line element 14. The communication line elements of the metering units are connected in series forming a communication bus 15. The communication bus may have extension line 16, which is connectable to the gateway unit 10. The communication bus can, for example, be a RS485 communication line. Electricity measurement data can be transmitted via the communication bus 15 (comprising said extension line) to the gateway unit unit 10 and transmitted forward to the external destination by the communication unit 11. It may also be possible that the gateway unit is integrated into one of the metering units or being a separate module, which is connectable to one of the metering units.

The equipment/arrangement further comprises a power source unit 17 connected to the first or other metering unit 8 in said series. The power source is arranged to supply power to all metering units 8A, 8B, 8C in the series. The power source 17 can an integrated element of the first metering unit 8A, or a separate element connected to the first metering unit 8A. The power source gets a supply voltage, like 3*230/400 V, via a voltage supply cable 24, which is connected to a substation's distribution rail 4, or thegateway unit 10. As said, the supply voltage information is also received by the power source unit, and also transmitted to each metering unit. The metering units 8A, 8B, 8C comprises interface/s 18 in order to connect the metering units in series, and the interfaces 18 are arranged to transmit power and data. So, the power from power source 17, and also the supply voltage information, are transmitted to each metering unit via the interfaces, and the interfaces are used to form said communication bus 15. The interfaces can be connected to with each other directly or using separate connection cables/elements.

Each metering unit 8A, 8B, 8C comprises at least one processing unit 19 to process measurements of the current transformers 9 in order to communicate measurement data via the communication bus 15. It is convenient that said processing unit/s 19 is/are arranged to calculate electrical power data and other possible electricity data from the measurements of the current transformers 9 and the supply voltage information to transmit power data and the other data via the communication bus 15.

The current transformers 9 are conveniently clamp type current transformers in order that they are easy to connect to the distribution line cables, even to existing cables in a substation. As said, the equipment or the arrangement may also comprise a voltage meter for example in each distribution line module 23A.

The gateway unit 10 and the metering units 8A, 8B, 8C comprises also a memory 21, 22, in order to keep necessary data in the memory, like configuration data, calculation data, software etc.. As said above, the figures are very schematic. Therefore the gatewayunit 10 and the metering units 8A, 8B, 8C may also have other elements, which are not illustrated in figure 3.

In the figures the metering units has three distribution line modules 23A, but as said the number of the distribution line modules can be at least two. Figure 4 illustrates another example of the metering unit 8D. This metering unit is otherwise similar to metering devices described above, except that it has only one distribution line module 23A. The metering unit/s having one distribution line module can be used with the other metering unit/s described above, so within the equipment/arrangement. Using the metering units having at least two distribution line modules 23A, and the metering units having one distribution line module, it is possible to make a metering equipment, which has a needed number of the distribution line modules. So for example, if the substation has five distribution lines, it is possible to use said metering units so that they provide also five distribution line modules.

As said above the electrical measurement data (and calculated/processed measurement data comprises power data, but other data can also be calculated/processed, for example, energy data, phase data in the cables of the distribution lines, quality parameters of the current in the distribution line cable. The quality parameters can, for example, be harmonic wave data and other wave form distortion data.

As said, the inventive equipment/arrangement is a distributed arrangement/equipment, which is scalable to the size and requirements of the substation. The inventive equipment/arrangement is to be used in substations having distribution lines of 1000 V or below 1000 V. The gateway unit takes care of the electricity data communication from all distribution lines to an external destination. Only one communication unit for the external communications is needed. Locally, one display can be used to look at electricity data of each distribution line. The metering units can be situated near each distribution line, and the gateway unit to a suitable place away from the distribution lines. This arrangement/equipment saves space if compared to the prior art solutions. The inventive equipment/arrangement in the substation is also easier to install and maintain than the prior art solutions, which are often cramped.

It is evident from the above that the invention is not limited to the embodiments described in this text but can be implemented in many other different embodiments within the scope of the independent claims.

## Claims

1. A substation electricity metering equipment, **characterised in that** the metering equipment comprises at least one metering unit (8A, 8B, 8C), which has at least two distribution line modules (23A), each distribution line module being connected to at least one current transformer (9) in order to measure current/s in a cable/s of a distribution line (6),
the metering equipment further comprising a power source unit (17) connected to or comprised in one of the metering units (8A, 8B, 8C),
and said at least one metering unit (8A, 8B, 8C) comprising also a communication line element (14)
and interface/s (18) in order to connect the metering units in series, said interface/s being arranged to connect the communication line elements (14) of the metering units in series, the communication line element/s together with the interface/s forming a communication bus (15) connectable to an external device, said interface/s being also arranged to transmit power from the power source unit (1)

2. A substation electricity metering equipment according to claim 1, **characterised in that** the power source unit (17) is arranged to receive a supply voltage, and arranged to transmit supply voltage information to the metering unit whereto the power source unit (17) is connected to or comprised in, and said interface/s being arranged to transmit the supply voltage information.

3. A substation electricity metering equipment according to claim 2, **characterised in that** each metering unit (8A, 8B, 8C) comprises at least one processing unit (19) to process measurements of the current transformers (9) and the supply voltage information in order to communicate measurement data via the communication bus (15).

4. A substation electricity metering equipment according to claim 3, **characterised in that** said processing unit/s (19) is arranged to calculate electrical power data from the measurements of the current transformers (9) and the supply voltage information to transmit power data via the communication bus (15).

5. A substation electricity metering equipment according to any of claims 1 - 4, **characterised in that** the power source (17) is an integrated element of the first metering unit (8A), or a separate element connected to the first metering unit (8A).

6. A substation electricity metering equipment according to any of claims 1 - 5, **characterised in that** the current transformers (9) are clamp type current transformers.

7. A substation electricity metering equipment according to any of claims 1 - 6, **characterised in that** it comprises at least one metering unit (8D), which has one distribution line module (23A), being connected to at least one current transformer (9) in order to measure current/s in a cable/s of a distribution line (6),
and the metering unit (8D) comprising also a communication line element (14) and interface/s (18) in order to connect the metering unit in series with the other metering unit/s, said interface/s being arranged to connect the communication line elements (14) of the metering units in series, said interface/s being also arranged to transmit power from the power source unit (1).

8. A substation electricity metering equipment according to claim 7, **characterised in that** each metering unit (8D) having one distribution line module (23A), comprises at least one processing unit (19) to process measurements of the current transformers (9) and the supply voltage information in order to communicate measurement data via the communication bus (15).

9. A substation electricity metering equipment according to claim 8, **characterised in that** said processing unit/s (19) is arranged to calculate electrical power data from the measurements of the current transformers (9) and the supply voltage information to transmit power data via the communication bus (15).

10. A substation electricity metering arrangement comprising comprises a gateway unit (10) having a communication unit (11) and at least one processor (12), and optionally a display (13), **characterised in that** it
the substation electricity metering arrangement comprises a metering equipment according to any of claims 1-7,
wherein the substation unit (10) is connected to the metering equipment for at least receiving metering data.

11. An arrangement according to claim 7, **characterised in that** said processor (12) is arranged to calculate electrical power data from the measurement data of the current transformers (9).
